# EUROPÄISCHE PATENTSCHRIFT

(11) **EP 1 442 308 B1**
(45) Veröffentlichungstag und Bekanntmachung des Hinweises auf die Patenterteilung: **08.06.2005**
(21) Anmeldenummer: 02783050.4
(22) Anmeldetag: 31.10.2002
(51) Int. Cl.: G01R 29/08

(54) **IMPEDANZSTABILISIERUNGSNETZWERK ZUR BESTIMMUNG DER ELEKTROMAGNETISCHEN STÖRSTRAHLUNG EINES MODEMS**
IMPEDANCE STABILIZATION NETWORK FOR DETERMINING THE ELECTROMAGNETIC INTERFERING RADIATION OF A MODEM
RESEAU DE STABILISATION D'IMPEDANCE SERVANT A DETERMINER LE RAYONNEMENT PARASITE ELECTROMAGNETIQUE D'UN MODEM

(30) Priorität: 09.11.2001 DE 10154697
(43) Veröffentlichungstag der Anmeldung: 04.08.2004
(73) Patentinhaber: Power Plus Communications AG, 68163 Mannheim (DE)
(72) Erfinder: HIRSCH, Holger, 59199 Bönen (DE)
(74) Vertreter: Kesselhut, Wolf, Dipl.-Ing.
(86) Internationale Anmeldenummer: PCT/EP2002/012147
(87) Internationale Veröffentlichungsnummer: WO 2003/040732

(56) Entgegenhaltungen:
- WO-A-95/27344
- ROHDE & SCHWARTZ KATALOG 1988, MONCHEN, Seiten 244-245 - 147
- 'Netznachbildung ESH 2-Z5 für Störstrahlungsmessungen.' NEUES VON ROHDE & SCHWARTZ Nr. 92, 1980, Seiten 30 - 31

## Beschreibung

Die Erfindung betrifft ein Impedanzstabilisierungsnetzwerk zur Bestimmung der elektromagnetischen Störstrahlung eines Modems, insbesondere eines Powerline-Modems zur Übertragung von elektronischen Daten über ein Leistungsstromnetz, gemäß dem Oberbegriff von Anspruch 1.

Auf dem Gebiet der Telekommunikation werden heutzutage für die Übertragung von elektronischen Daten zwischen Rechnern, beispielsweise im Bereich des Internets, neben speziell für diese Zwecke ausgebildeten herkömmlichen Datenleitungen in zunehmendem Maße die Leitungen des öffentlichen Stromnetzes verwendet.

Bei dieser in Fachkreisen als "Powerline " oder "Powerline Communication" (PLC) bezeichneten Technologie werden Datensignale neben der üblichen 50 Hz Spannung auf Stromleitungen des öffentlichen Stromnetzes aufmoduliert. Hierbei liegen die Pegel der verwendeten Signalspannungen in der Regel im Bereich von weniger als einem Volt und weisen Frequenzen im Bereich von 1,5 bis 30 MHz auf. Um sicherzustellen, dass die eingesetzten Powerline-Modems während ihres Betriebs keine elektromagnetische Störstrahlung aussenden, die die in den einschlägigen Verordnungen vorgeschriebenen Grenzwerte überschreitet, ist es erforderlich die vom Modem während des Betriebs abgestrahlte elektromagnetische Strahlung zu messen.

Bei der Bestimmung der von den oben genannten Modems emittierten Störstrahlung tritt aufgrund der verwendeten Hochfrequenz von 1,5 bis 30 MHz, mit der die Datensignale auf das 50 Hz Trägersignal des öffentlichen Stromnetzes aufmoduliert werden, das Problem auf, dass die zugehörigen Wellenlängen eine Größe von z.B. 10 Metern bis mehreren 100 Metern aufweisen. Da das Intensitätsmaximum der abgestrahlten Störstrahlung im Bereich von einem Viertel der Wellenlänge liegt, müssten im Falle einer direkten Messung der Störstrahlung die gegen den Einfluss von äußerer elektromagnetischer Störstrahlung abgeschirmten Räumlichkeiten zur Durchführung einer solchen direkten Messung eine ähnliche Größe aufweisen, so dass eine derartige direkte Messung der Störstrahlung in der Praxis in der Regel aus Kosten- und Platzgründen ausscheidet.

Aus den zuvor genannten Gründen werden daher seit einiger Zeit sogenannte Impedanzstabilisierungsnetzwerke (ISN) mit einer das öffentliche Stromnetz nachbildenden Netznachbildung (AMN) eingesetzt, durch welche das Verhalten eines öffentlichen Netzwerkes beim Betrieb von Telekommunikationseinrichtungen aller Art zur Ermittlung der Störstrahlung simuliert werden kann, ohne dass hierzu ein abgeschirmter Raum mit der oben bezeichneten Größe tatsächlich bereitgestellt werden muss.

Bei den Netznachbildungen - beispielsweise der vom Europäischen Komitee für elektrotechnische Normung 1998 erlassenen europäischen Norm EN 55022 -, die zum Vermessen von herkömmlichen Modems zusammen mit einem Impedanzstabilisierungsnetzwerk betrieben werden, lässt sich das Verhalten des Netzwerkes in bekannter Weise durch den sogenannten Longitudenal Conversion Loss, oder LCL-Wert, charakterisieren. Der LCL-Wert ist ein Maß für die Symmetrie der Impedanzen zwischen Phase und Erde, bzw. zwischen Nullleiter und Erde der Netznachbildung, und charakterisiert die Eigenschaften der Netznachbildung in soweit, als es für die Berechnung der tatsächlichen Störstrahlung aus den mit Hilfe eines Messempfängers am Impedanzstabilisierungsnetzwerk gemessenen Störsignalen im Rahmen der gesetzlichen Normen erforderlich ist. Der LCL kann in bekannter Weise mit Hilfe von Messgeräten bestimmt werden, die an die entsprechenden Anschlüsse des Netzwerks angeschlossen werden und durch Messung der Impedanzen den jeweils zugehörigen LCL-Wert direkt ermitteln.

Um die elektromagnetische Störstrahlung eines herkömmlichen Modems zu bestimmen, bei welchem der Telekommunikationsanschluss vom Netzteil getrennt ist, wird das Modem zur Bestimmung der Störstrahlung des Netzteils an eine Netznachbildung mit zugehörigem Impedanzstabilisierungsnetzwerk angeschlossen, und die Störstrahlung des Netzteils allein ermittelt, ohne dass das Modem Daten empfängt oder aussendet. In einem weiteren Schritt wird die elektromagnetische Störstrahlung des Modems beim Empfang, bzw. bei der Aussendung von Daten dadurch bestimmt, dass der Telekommunikationsport des Modems mit einer entsprechenden Netzwerknachbildung und einem zugeordneten Impedanzstabilisierungsnetzwerk für das Datennetz betrieben wird.

Aus der WO 95 273 44 ist eine elektronische Filterschaltung zum Einsatz zwischen einer Gleichspannungsstromversorgung und einem Datenübertragungsnetzwerk bekannt, bei der ein einzelnes Paar von Kondensatoren als Übertragungsweg sowohl für die Signale als auch die elektrische Leistung zum Einsatz gelangt. Die beschriebene Filterschaltung bezieht sich nicht auf die Problematik der Störstrahlungsbestimmung.

Weiterhin ist aus dem Katalog der Firma "Rohde & Schwarz", 1988 Seiten 244, 245 und 247, eine Vierleiter-V-Netznachbildung mit der Bezeichnung "ESH 2-Z5" bekannt. In dem Dokument "NEUES VON ROHDE & SCHWARZ", Heft 92 (Winter 1980/81), S. 30 und 31, ist hierbei ergänzend ausgeführt, dass mit Hilfe eines Schalters auf der Frontplatte einer von vier Pfaden (N, R1, S2, T3) anwählbar ist, dessen Störspannung an den Ausgang zum Messempfänger geführt werden soll. Obgleich bei der beschriebenen Netznachbildung zur netzseitigen Entkopplung ein Entkopplungsglied zum Einsatz gelangt, wird lediglich eine einfache Entkopplung der Phase vorgenommen, wobei durch den Einsatz des Schalters zur Wahl eines der vier Pfade ein symmetrisches Auskoppelnetzwerk umfassend einen ersten und zweiten Widerstand und Spulen nicht erforderlich ist.

Aufgrund ihres Aufbaus fallen bei den Powerline-Modems der Telekommunikationsanschluss für die Datenübertragung und der Anschluss für die Stromversorgung über das öffentliche 50 Hz-Stromnetz zusammen, wodurch sich das Problem ergibt, dass die Powerline-Modems mit den bekannten Netzwerknachbildungen und Impedanzstabilisierungsnetzwerken nicht in Hinblick auf die abgestrahlte elektromagnetische Störstrahlung vermessen werden können.

Demgemäß ist es eine Aufgabe der Erfindung, ein Impedanzstabilisierungsnetzwerk zu schaffen, mit welchem die elektromagnetische Störstrahlung eines Powerline-Modems bestimmt werden kann, welches zur Übertragung von elektronischen Daten über ein Leistungsstromnetz, insbesondere über das öffentliche Stromnetz, eingesetzt wird.

Diese Aufgabe wird gemäß der Erfindung durch die Merkmale von Anspruch 1 gelöst.

Weitere Merkmale der Erfindung sind in den Unteransprüchen enthalten.

Durch die Erfindung ergibt sich der Vorteil, dass auch Powerline-Modems, bei denen der Telekommunikationsport und der Netzanschluss bauartbedingt zusammenfallen, in einer exakt festlegbaren und nachvollziehbaren Weise in Hinblick auf die während des Ruhebetriebs, bzw. während des Datensende- und/oder Empfangbetriebes entstehende elektromagnetische Störstrahlung mit hoher Präzision vermessen werden können, ohne dass hierzu eine gegen externe Störstrahlung abgeschirmte Messkabine benötigt wird, deren Abmessungen im Bereich der Wellenlänge der durch das Modem erzeugten Hochfrequenzsignale von 1,5 MHz bis 30 MHz liegt.

Die Erfindung wird nachfolgend mit Bezug auf die Zeichnung anhand bevorzugter Ausführungsformen beschrieben.

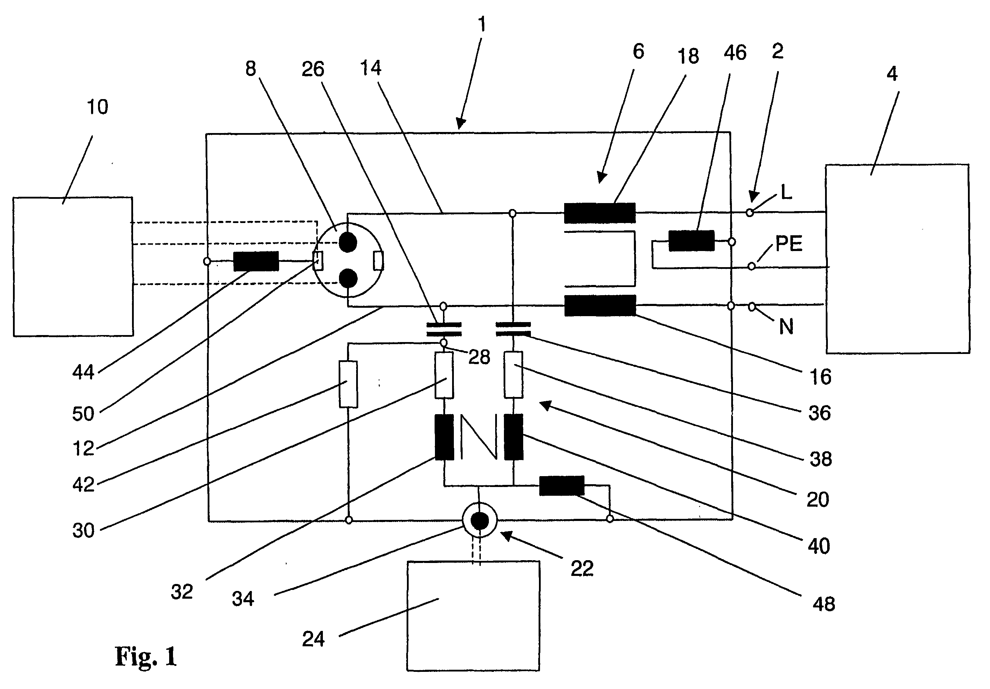

In der einzigen Zeichnung zeigt
- Fig. 1: eine schematische Darstellung des erfindungsgemäßen Impedanzstabilisierungsnetzwerkes zur Bestimmung der elektromagnetischen Störstrahlung eines Powerline-Modems zusammen mit einem angeschlossenen Modem, einem zugehörigen Messempfänger und einer mit dem Impedanzstabilisierungsnetzwerk verbundenen Zusatz-/Hilfseinrichtung (AE).

Wie in Fig. 1 dargestellt ist, umfasst das erfindungsgemäße Impedanzstabilisierungsnetzwerk 1 einen Netzanschluss 2, über den das Impedanzstabilisierungsnetzwerk 1 mit einer bekannten Zusatz-/Hilfseinrichtung (AE) 4 verbunden ist, welche dem Impedanzstabilisierungsnetzwerk 1 über die mit "N", "PE" und "L" bezeichneten Zuleitungen einen elektrischen Wechselstrom mit einer Frequenz von vorzugsweise 50 Hz zuführt. Die Buchstaben "N", "PE" und "L" stehen hierbei für den Nulleiter, die Erde oder den Schutzleiter und den Leiter oder die Phase der Zusatz-/Hilfseinrichtung (AE) 4.

Der Netzanschluss 2 ist über ein Entkopplungsglied 6 mit einem Anschlussport 8 verbunden, der vorzugsweise die Form einer in Fig. 1 schematisch dargestellten Steckdose besitzt, und der zum Anschluss eines zu testenden Prüflings (EUT) -hier eines Powerline-Modems- 10 dient. Die elektrische Verbindung zwischen dem Entkopplungsglied 6 und dem Anschlussport 8 erfolgt über eine erste Leitung 12 und eine zweite Leitung 14. Die erste Leitung 12 ist mit einer ersten Spule 16 und die zweite Leitung 14 mit einer zweiten Spule 18 des Entkopplungsgliedes 6 verbunden, welche zusammen eine stromkompensierte Drossel bilden, an die der Nulleiter N und der Leiter oder die Phase L der Zusatz-/Hilfseinrichtung 4 angeschlossen sind. Die erste Spule 16 und/oder die zweite Spule 18 besitzen bei der bevorzugten Ausführungsform der Erfindung eine Größe von vorzugsweise jeweils 71 mH.

Das Entkopplungsglied 6 entkoppelt die vom Modem 10 über den Anschlussport 8 zugeführten hochfrequenten und vorzugsweise asymmetrischen Wechselstromsignale mit einer Frequenz im Bereich zwischen 1,5 MHz und 30 MHz vom Netzanschluss 2, die vom Modem 10 auf den niederfrequenten Wechselstrom des Netzanschlusses mit einer Frequenz von ca. 50 Hz aufmoduliert werden.

Wie der Darstellung von Fig. 1 weiterhin entnommen werden kann, weist das Impedanzstabilisierungsnetzwerk 1, welches vorzugsweise in einer nicht näher bezeichneten abgeschirmten Box untergebracht ist, einen Auskoppelteil 20 auf, welcher die erste Leitung 12 und die zweite Leitung 14 mit einem Ausgang 22 zum Anschluss eines Messempfängers 24 verbindet. Der Ausgang 22 wird hierbei vorzugsweise durch eine bekannte Steckbuchse gebildet, in welche ein entsprechend ausgebildeter und in Fig. 1 nicht näher bezeichneter Stecker des Messempfängers 24 eingesteckt werden kann, um die elektromagnetische Störstrahlung in Form von elektrischen Signalen zu Messen. Die Messung erfolgt hierbei zum einen während des Sendebetriebs des Modems 10, um in erster Linie die bei der Übertragung von Daten hervorgerufene Störstrahlung zu bestimmen; und zum anderen während des sogenannten Idle-Betriebs oder Leerlaufbetries des Modems 10, bei welchem dieses zwar an den Anschlussport 8 angeschlossen ist, jedoch keine Daten übersendet, um die durch das Stromversorgungsnetzteil des Modems 10 erzeugte elektromagnetische Störstrahlung zu ermitteln. Die am Ausgang 22 vom Messempfänger 24 gemessenen Signale besitzen dabei eine Größe im Bereich von einigen µV.

Der Auskoppelteil 20 umfasst bei der bevorzugten Ausführungsform der Erfindung einen ersten Kondensator 26, der über eine Verbindungsleitung 28 mit einem ersten Widerstand 30 verbunden ist, welcher vorzugsweise über eine erste Spule 32 an den Nulleiter-Kontakt 34 des Ausgangs 22 für den Messempfänger 24 angeschlossen ist.

Bei der bevorzugten Ausführungsform der Erfindung umfasst der Auskoppelteil 20 weiterhin vorzugsweise einen zweiten Kondensator 36, der mit seinem einen Ende mit der zweiten Leitung 14 verbunden ist, und der mit seinem anderen Ende über einen zweiten Widerstand 38 - vorzugsweise ebenfalls ein ohmscher Widerstand - und eine zweite Spule 40 in gleicher Weise an den Nulleiter-Kontakt 34 des Ausgangs 22 angeschlossen ist.

Der erste Kondensator 26 bildet hierbei zusammen mit dem ersten Widerstand 30 einen ersten Hochpassfilter zum Trennen des von der Netzwerknachbildung 4 zugeführten Starkstromanteils mit einer Frequenz von 50 Hz vom Ausgang 22. In gleicher Weise bildet der zweite Kondensator 36 zusammen mit dem nachgeordneten ohmschen Widerstand 38 einen zweiten Hochpassfilter, der in gleicher Weise wie der erste Hochpassfilter dazu dient, den von der Netzwerknachbildung 4 zugeführten Starkstromanteil vom Ausgang 22 zu trennen.

Der erste Kondensator 26 und/oder der zweite Kondensator 36 weisen vorzugsweise eine Kapazität im Bereich von 470 nF auf, und die zugehörigen ersten und zweiten ohmschen Widerstände 30 und 38 haben vorzugsweise beide denselben Widerstandswert von vorzugsweise 200 Ohm.

Die erste Spule 32 und die zweite Spule 40 bilden bei der bevorzugten Ausführungsform der Erfindung vorzugsweise ein magnetisch gekoppeltes Spulenpaar.

Das Auskoppelteil 20 ist durch die Wahl der beiden Kondensatoren 26 und 36, die nachgeordneten ohmschen Widerstände 30 und 38 sowie die beiden magnetisch gekoppelten Spulen vorzugsweise derart dimensioniert, dass sich zusammen mit einer Eingangsimpedanz des Messempfängers 24 von beispielsweise 50 Ohm eine asymmetrische Impedanz von 150 Ohm ergibt.

Wie der Darstellung von Fig. 1 weiterhin zu entnehmen ist, ist die Verbindungsleitung 28 zwischen dem ersten Kondensator 26 und dem ersten ohmschen Widerstand 30 in erfindungsgemäßer Weise mit dem einen Ende eines weiteren Widerstandes 42 verbunden, dessen anderes Ende vorzugsweise an den Nulleiter N des Netzanschlusses 2 angeschlossen ist.

Obwohl die Möglichkeit besteht, den weiteren Widerstand 42 als Impedanz auszubilden, ist dieser weitere Widerstand 42 vorzugsweise ein ohmscher Widerstand, der bei der bevorzugten Ausführungsform der Erfindung eine solche Größe besitzt, dass der LCL-Wert der das Impedanzstabilisierungsnetzwerk 1 und die Zusatz-/Hilfseinrichtung 4 enthaltenden Netznachbildung im Bereich zwischen 6 dB und 40 dB liegt.

Der weitere ohmsche Widerstand 42 kann zum einen als ein variabler ohmscher Widerstand, d.h. als ein Potentiometer, ausgebildet sein, wodurch sich die Möglichkeit ergibt, dass der LCL-Wert durch eine Veränderung des Widerstandes 42 bei gleichzeitiger Messung des LCL-Wertes am Netzanschluss auf einen gewünschten Wert eingestellt werden kann, beispielsweise einen Wert, der in den einschlägigen Verordnungen zur Untersuchung der elektromagnetischen Störstrahlung für Netznachbildungen vorgeschrieben ist.

Der weitere ohmsche Widerstand besitzt in der variablen Ausgestaltung vorzugsweise eine solche Größe, dass der LCL-Wert der Netznachbildung im Bereich zwischen 6 dB und 40 dB liegt.

Weiterhin ergibt sich durch das zuvor genannte Vorgehen bei der Verwendung eines veränderlichen Widerstandes der Vorteil, dass der Widerstand 42 nach dem Einstellen des LCL-Wertes auf einen gewünschten Wert durch einen festen ohmschen Widerstand ersetzt werden kann, um z.B. ein genormtes oder standardisiertes Impedanzstabilisierungsnetzwerk 1 mit einem fest vorgegebenen LCL-Wert zu schaffen, der für alle möglichen anzuschließenden Powerline-Modems 10 ein und dieselbe Größe besitzt. Hierbei kann der weitere ohmsche Widerstand 42 beispielsweise einen festen Wert von 990 Ohm für Netznachbildungen mit einem LCL-Wert von 24 dB oder aber einen Wert von 1880 Ohm für Netzwerknachbildungen mit einem LCL-Wert von 30 dB aufweisen.

Weiterhin ist es denkbar, den weiteren Widerstand 42 bei der Ausbildung als Impedanz direkt an die erste Leitung 12 anzuschließen.

Gemäß einer weiteren Ausführungsform der Erfindung sind mindestens eine, vorzugsweise jedoch drei weitere Drosseln 44, 46 und 48 in Form von Drosselspulen vorgesehen, um den Messempfänger 24 vor Überspannungen aus dem Leistungsstromnetz zu schützen.

Die erste Drosselspule 44 ist hierbei vorzugsweise zwischen dem Schutzkontakt 50 des Anschlussports 8 und dem Nulleiter N, die zweite Drosselspule 46 zwischen dem Schutzleiter PE und dem Nulleiter N des Netzanschlusses 2 und die dritte Drosselspule 48 zwischen dem Nulleiter N des Netzanschlusses 2 und den zusammengeführten Enden der ersten und zweiten Spulen 32 und 40 des Auskoppelteils 20 angeordnet. Die Drosseln 44, 46 und 48 sind bei der bevorzugten Ausführungsform der Erfindung in der Weise dimensioniert, dass die Impedanz bei einer Frequenz von 50 Hz im Wesentlichen 0 Ohm beträgt, und bei einer Frequenz von mehr als 150 kHz im Wesentlichen größer 150 Ohm ist.

Gemäß einem erfindungsgemäßen Verfahren zur Bestimmung der elektromagnetischen Störstrahlung eines Powerline-Modems zur Übertragung von elektronischen Daten über ein Leistungsstromnetz, insbesondere das öffentliche Stromnetz, wird die elektromagnetische Störstrahlung mit Hilfe des zuvor beschriebenen Impedanzstabilisierungsnetzwerks 1 bestimmt, wobei der LCL-Wert der Netznachbildung durch eine entsprechende Wahl des weiteren Widerstandes 42 vorzugsweise auf einen Wert von 25 dB oder 30 dB festgelegt ist. Die Durchführung des erfindungsgemäßen Verfahrens erfolgt dabei in der Weise, dass ein Powerline-Modem 10 an den Anschlussport 8 angeschlossen wird, welches über ein nicht dargestelltes Twisted-Pair-Kabel mit einem Rechner, beispielsweise einem Laptop, verbunden ist. Um bei der Messung auftretende Gleichtaktsignale zu unterdrücken, wird vorzugsweise eine nicht dargestellte Absorptionszange über das Verbindungskabel zum Laptop gelegt und ein kontinuierlicher Sendedatenstrom von beispielsweise 270 kbit/s bei einer eingestellten Bitrate von 2,5 Mbit/s eingestellt, während die Störsignale mit dem Messempfänger 34 aufgenommen werden.

### Bezugszeichenliste

- 1: Impedanzstabilisierungsnetzwerk
- 2: Netzanschluss
- L: Leiter
- N: Nulleiter
- PE: Erde oder Schutzleiter
- 4: Zusatz-/Hilfseinrichtung
- 6: Entkopplungsglied
- 8: Anschlussport
- 10: Powerline-Modem
- 12: erste Leitung
- 14: zweite Leitung
- 16: erste Spule
- 18: zweite Spule
- 20: Auskoppelteil
- 22: Ausgang für Messempfänger
- 24: Messempfänger
- 26: erster Kondensator
- 28: Verbindungsleitung
- 30: erster Widerstand
- 32: erste Spule
- 34: Nulleiterkontakt
- 36: zweiter Kondensator
- 38: zweiter Widerstand
- 40: zweite Spule
- 42: weiterer Widerstand
- 44: Drossel
- 46: Drossel
- 48: Drossel
- 50: Schutzleiter des Anschlussports

## Patentansprüche

1. Impedanzstabilisierungsnetzwerk (1) zur Bestimmung der elektromagnetischen Störstrahlung eines Modems (10) zur Übertragung von elektronischen Daten über ein Leistungsstromnetz, insbesondere das öffentliche Stromnetz,
**gekennzeichnet durch**
einen Netzanschluss (2) zur Zufuhr eines elektrischen Wechselstromes (L, PE, N), insbesondere aus einer Zusatz-/Hilfseinrichtung (4), einen Anschlussport (8) zum Anschluss des Modems (10) an das Impedanzstabilisierungsnetzwerk (1), ein mit dem Anschlussport (8) über eine erste und zweite elektrische Leitung (12, 14) verbundenes Entkopplungsglied (6) zur Entkopplung des Netzanschlusses (2) von Hochfrequenzsignalen, die **durch** das Modem (10) über den Anschlussport (8) zugeführt und auf den Wechselstrom aufmoduliert werden, einen einen ersten Kondensator (26) und einen diesem nachgeordneten ersten Widerstand (30) enthaltenden Auskoppelteil (20), welcher die erste und zweite Leitung (12,14) mit einem Ausgang (22) zum Anschluss eines Messempfängers (24) verbindet, mittels welchem die Störstrahlung in Form von elektrischen Störsignalen gemessen werden kann, sowie **durch** einen weiteren Widerstand (42), der den ersten Kondensator (26) mit dem Nulleiter (N) des Netzanschlusses (2) verbindet.

2. Impedanzstabilisierungsnetzwerk nach Anspruch 1,
**dadurch gekennzeichnet, dass**
der weitere Widerstand (42) ein ohmscher Widerstand ist.

3. Impedanzstabilisierungsnetzwerk nach Anspruch 1 oder 2,
**dadurch gekennzeichnet, dass**
der weitere Widerstand (42) mit seinem einen Ende an eine den ersten Kondensator (26) mit dem ersten ohmschen Widerstand (30) verbindende elektrische Verbindungsleitung (28) angeschlossen ist.

4. Impedanzstabilisierungsnetzwerk nach einem der vorhergehenden Ansprüche,
**dadurch gekennzeichnet, dass**
der weitere ohmsche Widerstand (42) eine solche Größe besitzt, dass der LCL - Wert einer das Impedanzstabilisierungsnetzwerk (1) und die Zusatz-/Hilfseinrichtung (4) enthaltenden Netznachbildung im Bereich zwischen 6dB und 40 dB liegt.

5. Impedanzstabilisierungsnetzwerk nach einem der vorhergehenden Ansprüche,
**dadurch gekennzeichnet, dass**
der weitere ohmsche Widerstand (42) einen festen Wert aufweist, derart, dass der LCL-Wert einer das Impedanzstabilisierungsnetzwerk (1) und die Zusatz-/Hilfseinrichtung (4) enthaltenden Netznachbildung im Wesentlichen eine feste Größe von 25 dB oder 30 dB besitzt.

6. Impedanzstabilisierungsnetzwerk nach Anspruch 5,
**dadurch gekennzeichnet, dass**
der weitere ohmsche Widerstand (42) einen Wert von 990 Ohm für Netznachbildungen mit einem LCL-Wert von 25 dB oder einen Wert von 1,88 kOhm für Netznachbildungen mit einem LCL-Wert von 30 dB aufweist.

7. Impedanzstabilisierungsnetzwerk nach einem der Ansprüche 2 bis 4,
**dadurch gekennzeichnet, dass**
der weitere ohmsche Widerstand (42) einen variabler ohmscher Widerstand ist.

8. Impedanzstabilisierungsnetzwerk nach einem der vorhergehenden Ansprüche,
**dadurch gekennzeichnet, dass**
der Auskoppelteil (20) einen zweiten Kondensator (36), einen dem zweiten Kondensator (36) nachgeordneten zweiten ohmschen Widerstand (38) und ein mit dem ersten und zweiten ohmschen Widerstand (30,38) gemeinsam verbundenes magnetisch gekoppeltes Spulenpaar (32, 40) umfasst.

9. Impedanzstabilisierungsnetzwerk nach Anspruch 8,
**dadurch gekennzeichnet, dass**
der erste Kondensator (26) einen Hochpassfilter zum Trennen des von der Zusatz-/Hilfseinrichtung (4) zugeführten Starkstromanteils mit einer Frequenz von im Wesentlichen 50 Hz vom Ausgang (22) zum Anschluss des Messempfängers (24) bildet.

10. Impedanzstabilisierungsnetzwerk nach Anspruch 8 oder 9,
**dadurch gekennzeichnet, dass**
der erste Kondensator (26) und/oder der zweite Kondensator (36) eine Kapazität von 470 nF besitzen.

11. Impedanzstabilisierungsnetzwerk nach einem der vorhergehenden Ansprüche,
**dadurch gekennzeichnet, dass**
das Entkopplungsglied (6) zur Entkopplung des Anschlussports (8) vom Netzanschluss (2) eine stromkompensierte Drossel (16, 18) enthält.

12. Impedanzstabilisierungsnetzwerk nach Anspruch 11,
**dadurch gekennzeichnet, dass**
die stromkompensierte Drossel eine erste Spule (16) umfasst, die mit ihrem ersten Ende mit dem Nulleiter (N) des Netzanschlusses und mit ihrem zweiten Ende mit der ersten Leitung (12) verbunden ist.

13. Impedanzstabilisierungsnetzwerk nach Anspruch 11 oder 12,
**dadurch gekennzeichnet, dass**
die stromkompensierte Drossel eine zweite Spule (18) umfasst, die mit ihrem ersten Ende mit dem Leiter (L) des Netzanschlusses (2) und mit ihrem zweiten Ende mit der zweiten Leitung (14) verbunden ist.

14. Impedanzstabilisierungsnetzwerk nach einem der vorhergehenden Ansprüche,
**dadurch gekennzeichnet, dass**
mindestens eine weitere Drossel (44, 46, 48) vorgesehen ist, welche den Messempfänger (24) gegen Überspannungen schützt.

15. Impedanzstabilisierungsnetzwerk nach Anspruch 14,
**dadurch gekennzeichnet, dass**
das die mindestens eine weitere Drossel (44, 46, 48) in der Weise dimensioniert ist, dass bei einer Frequenz von 50 Hz die Impedanz im Wesentlichen 0 Ohm und bei einer Frequenz größer 150 kHz die Impedanz im Wesentlichen größer 150 Ohm ist.

16. Impedanzstabilisierungsnetzwerk nach einem der Ansprüche 14 oder 15,
**dadurch gekennzeichnet, dass**
insgesamt drei weitere Drosseln (44, 46, 48) vorgesehen sind, die zwischen dem Nulleiter (N) des Netzanschlusses (2) und dem Schutzleiter des Anschlussports (8) und/oder dem Spulenpaar (32, 40) des Auskoppelteils (20) und/oder der Erde (PE) der Zusatz-/Hilfseinrichtung (4) angeordnet sind.

17. Verfahren zur Bestimmung der Störstrahlung eines Modems zur Übertragung von elektronischen Daten über das öffentliche Stromnetz,
**dadurch gekennzeichnet, dass**
die Bestimmung der Störstrahlung mit Hilfe eines Impedanzstabilisierungsnetzwerks nach einem der vorhergehenden Ansprüche erfolgt.

18. Verfahren nach Anspruch 17,
**dadurch gekennzeichnet, dass**
die Bestimmung der Störstrahlung unter Einsatz einer Absorptionszange zur Gleichtaktsignalunterdrückung erfolgt.

## Claims

1. Impedance stabilisation network (1) for determining the electromagnetic interference of a modem (10) for transmitting electronic data via a power network, in particular the public power network, **characterised by** a network connection (2) for supplying an electric alternating current (L, PE, N), in particular from a supplementary/auxiliary device (4), a connection port (8) for connecting the modem (10) to the impedance stabilisation network (1), an isolating member (6), which is connected to the connection port (8) via a first and second electric line (12, 14), for isolating the network connection (2) from high-frequency signals that are supplied by the modem (10) via the connection port (8) and modulated to the alternating current, a decoupling part (20), which contains a first capacitor (26) and a first resistor (30) connected downstream therefrom and which connects the first and second lines (12, 14) to an output (22) for connecting a measurement receiver (24), by means of which the interference may be measured in the form of electric interference signals, and by a further resistor (42), which connects the first capacitor (26) to the neutral conductor (N) of the network connection (2).

2. Impedance stabilisation network according to claim 1, **characterised in that** the further resistor (42) is an ohmic resistor.

3. Impedance stabilisation network according to either claim 1 or claim 2, **characterised in that** one end of the further resistor (42) is connected to an electric connection line (28) connecting the first capacitor (26) to the first ohmic resistor (30).

4. Impedance stabilisation network according to any one of the preceding claims, **characterised in that** the further ohmic resistor (42) is of such a size that the LCL value of a network simulation containing the impedance stabilisation network (1) and the supplementary/auxiliary device (4) is in the range between 6 dB and 40 dB.

5. Impedance stabilisation network according to any one of the preceding claims, **characterised in that** the fixed ohmic resistor (42) has a fixed value such that the LCL value of a network simulation containing the impedance stabilisation network (1) and the supplementary/auxiliary device (4) substantially has a fixed variable of 25 dB or 30 dB.

6. Impedance stabilisation network according to claim 5, **characterised in that** the further ohmic resistor (42) exhibits a value of 990 Ohms for network simulations having an LCL value of 25 dB or a value of 1.88 kOhms for network simulations having an LCL value of 30 dB.

7. Impedance stabilisation network according to any one of claims 2 to 4, **characterised in that** the further ohmic resistor (42) is a variable ohmic resistor.

8. Impedance stabilisation network according to any one of the preceding claims, **characterised in that** the decoupling part (20) comprises a second capacitor (36), a second ohmic resistor (38), which is connected downstream of the second capacitor (36), and a magnetically coupled coil pair (32, 40) that is jointly connected to the first and second ohmic resistors (30, 38).

9. Impedance stabilisation network according to claim 8, **characterised in that** the first capacitor (26) forms a high-pass filter for separating the heavy current content, supplied by the supplementary/auxiliary device (4), having a frequency of substantially 50 Hz from the output (22) for connecting the measurement receiver (24).

10. Impedance stabilisation network according to either claim 8 or claim 9, **characterised in that** the first capacitor (26) and/or the second capacitor (36) have a capacity of 470 nF.

11. Impedance stabilisation network according to any one of the preceding claims, **characterised in that** the isolating member (6) for isolating the connection port (8) from the network connection (2) contains a current-compensated choke (16, 18).

12. Impedance stabilisation network according to claim 11, **characterised in that** the current-compensated choke comprises a first coil (16), the first end of which is connected to the neutral conductor (N) of the network connection and the second end of which is connected to the first line (12).

13. Impedance stabilisation network according to either claim 11 or claim 12, **characterised in that** the current-compensated choke comprises a second coil (18), the first end of which is connected to the conductor (L) of the network connection (2) and the second end of which is connected to the second line (14).

14. Impedance stabilisation network according to any one of the preceding claims, **characterised in that** at least one further choke (44, 46, 48), which protects the measurement receiver (24) from excess voltages, is provided.

15. Impedance stabilisation network according to claim 14, **characterised in that** at least one further choke (44, 46, 48) is designed such that at a frequency of 50 Hz, the impedance is substantially 0 Ohms and at a frequency greater than 150 kHz, the impedance is substantially greater than 150 Ohms.

16. Impedance stabilisation network according to either claim 14 or claim 15, **characterised in that**, in total, three further chokes (44, 46, 48), which are arranged between the neutral conductor (N) of the network connection (2) and the protective conductor of the connection port (8) and/or the coil pair (32, 40) of the decoupling part (20) and/or the earth (PE) of the supplementary/auxiliary device (4), are provided.

17. Method for determining the interference of a modem for transmitting electronic data via the public power network, **characterised in that** the interference is determined using an impedance stabilisation network according to any one of the preceding claims.

18. Method according to claim 17, **characterised in that** interference is determined using absorption pliers for common mode signal rejection.

## Revendications

1. Réseau de stabilisation d'impédance (1) servant à déterminer le rayonnement parasite électromagnétique d'un modem (10) pour la transmission de données électroniques à travers un réseau de puissance, en particulier le réseau de distribution public, **caractérisé par** un raccordement au secteur (2) pour l'arrivée d'un courant alternatif électrique (L, PE, N), fourni en particulier par un dispositif auxiliaire/accessoire (4), par un port (8) pour le raccordement du modem (10) au réseau de stabilisation d'impédance (1), par un découpleur (6) relié au port (8) par une première et une seconde ligne électrique (12, 14) pour découpler le raccordement au secteur (2) de signaux à haute fréquence, transmis par le modem (10) à travers le port (8) et modulés sur le courant alternatif, par une partie de découplage (20) comprenant un premier condensateur (26) et une première résistance (30) en aval de ce dernier, et qui relie la première et la seconde ligne (12, 14) à une sortie (22) pour le raccordement d'un récepteur de mesure (24), au moyen duquel le rayonnement parasite peut être mesuré sous forme de signaux parasites électriques, ainsi que par une autre résistance (42) qui relie le premier condensateur (26) au conducteur neutre (N) du raccordement au secteur (2).

2. Réseau de stabilisation d'impédance suivant la revendication 1, **caractérisé en ce que** l'autre résistance (42) est une résistance ohmique.

3. Réseau de stabilisation d'impédance suivant l'une des revendications 1 et 2, **caractérisé en ce que** l'autre résistance (42) est raccordée par l'une de ses extrémités à une ligne de jonction électrique (28) qui relie le premier condensateur (26) à la première résistance ohmique (30).

4. Réseau de stabilisation d'impédance suivant l'une des revendications précédentes, **caractérisé en ce que** l'autre résistance ohmique (42) présente une valeur telle que la valeur LCL d'un réseau fictif comportant le réseau de stabilisation d'impédance (1) et le dispositif auxiliaire/accessoire (4) se situe dans la plage comprise entre 6dB et 40 dB.

5. Réseau de stabilisation d'impédance suivant l'une des revendications précédentes, **caractérisé en ce que** l'autre résistance ohmique (42) présente une valeur fixe, de telle sorte que la valeur LCL d'un réseau fictif, comportant le réseau de stabilisation d'impédance (1) et le dispositif auxiliaire/accessoire (4), présente essentiellement une valeur fixe de 25 dB ou 30 dB.

6. Réseau de stabilisation d'impédance suivant la revendication 5, **caractérisé en ce que** l'autre résistance ohmique (42) présente une valeur de 990 ohms pour des réseaux fictifs d'une valeur LCL de 25 dB ou une valeur de 1,88 kohms pour des réseaux fictifs d'une valeur LCL de 30 dB.

7. Réseau de stabilisation d'impédance suivant l'une des revendications 2 à 4, **caractérisé en ce que** l'autre résistance ohmique (42) est une résistance ohmique variable.

8. Réseau de stabilisation d'impédance suivant l'une des revendications précédentes, **caractérisé en ce que** la partie de découplage (20) comprend un second condensateur (36), une seconde résistance ohmique (38) montée en aval du second condensateur (36), et une paire de bobines (32, 40) couplée magnétiquement, reliée conjointement à la première et à la seconde résistance ohmique (30, 38).

9. Réseau de stabilisation d'impédance suivant la revendication 8, **caractérisé en ce que** le premier condensateur (26) forme un filtre passe-haut pour séparer la fraction de courant fort d'une fréquence d'essentiellement 50 Hz, fournie par le dispositif auxiliaire/accessoire (4), de la sortie (22) pour le raccordement au récepteur de mesure (24).

10. Réseau de stabilisation d'impédance suivant l'une des revendications 8 et 9, **caractérisé en ce que** le premier condensateur (26) et/ou le second condensateur (36) présentent une capacité de 470 nF.

11. Réseau de stabilisation d'impédance suivant l'une des revendications précédentes, **caractérisé en ce que** le découpleur (6) comporte une inductance compensée en courant (16, 18) pour découpler le port (8) du raccordement au secteur (2).

12. Réseau de stabilisation d'impédance suivant la revendication 11, **caractérisé en ce que** l'inductance compensée en courant comprend une première bobine (16), qui est reliée par sa première extrémité au conducteur neutre (N) du raccordement au secteur et par sa seconde extrémité à la première ligne (12).

13. Réseau de stabilisation d'impédance suivant l'une des revendications 11 et 12, **caractérisé en ce que** l'inductance compensée en courant comprend une seconde bobine (18), qui est reliée par sa première extrémité au conducteur (L) du raccordement au secteur (2) et par sa seconde extrémité à la seconde ligne (14).

14. Réseau de stabilisation d'impédance suivant l'une des revendications précédentes, **caractérisé en ce qu'**il est prévu au moins une autre inductance (44, 46, 48) qui protège le récepteur de mesure (24) contre des surtensions.

15. Réseau de stabilisation d'impédance suivant la revendication 14, **caractérisé en ce que** la au moins une autre inductance (44, 46, 48) est dimensionnée de telle manière que l'impédance soit essentiellement de 0 ohms pour une fréquence de 50 Hz et essentiellement supérieure à 150 ohms pour une fréquence de plus de 150 kHz.

16. Réseau de stabilisation d'impédance suivant l'une des revendications 14 et 15, **caractérisé en ce que** trois autres inductances (44, 46, 48) sont prévues au total, qui sont disposées entre le conducteur neutre (N) du raccordement au secteur (2) et le conducteur de protection du port (8) et/ou la paire de bobines (32, 40) de la partie de découplage (20) et/ou la terre (PE) du dispositif auxiliaire/accessoire (4).

17. Procédé de détermination du rayonnement parasite d'un modem pour la transmission de données électroniques à travers le réseau de distribution public, **caractérisé en ce que** la détermination du rayonnement parasite est effectuée à l'aide d'un réseau de stabilisation d'impédance suivant l'une des revendications précédentes.

18. Procédé suivant la revendication 17, **caractérisé en ce que** la détermination du rayonnement parasite est effectuée en utilisant une pince d'absorption pour la réjection de signaux de mode commun.
